Europäisches Patentamt

**European Patent Office**

**Office européen des brevets**

(11) Veröffentlichungsnummer: **0 109 526**

**A2**

(12) **EUROPÄISCHE PATENTANMELDUNG**

(21) Anmeldenummer: **83110097.9**

(22) Anmeldetag: **10.10.83**

(51) Int. Cl.³: **H 05 K 13/02**

(30) Priorität: **27.10.82 DE 3239852**

(43) Veröffentlichungstag der Anmeldung:
**30.05.84 Patentblatt 84/22**

(84) Benannte Vertragsstaaten:
**AT BE CH DE FR GB IT LI SE**

(71) Anmelder: **SIEMENS AKTIENGESELLSCHAFT**
**Berlin und München Wittelsbacherplatz 2**
**D-8000 München 2(DE)**

(84) Benannte Vertragsstaaten:
**BE CH DE FR GB IT LI SE**

(71) Anmelder: **Siemens Bauelemente OHG**
**Unterlaufenegger Strasse**
**A-8530 Deutschlandsberg(AT)**

(84) Benannte Vertragsstaaten:
**AT**

(72) Erfinder: **Hesse, Bruno, Ing. grad.**
**Gamsgebirg 88**
**A-8524 Bad Gams(AT)**

(54) Verfahren zum Abtrennen der über einen Rand eines Gurtbandes überstehenden Teile von Stromzuführungsdrähten radial bedrahteten elektrischer Bauelemente und Gurtband mit solchen Bauelementen.

(57) Das Verfahren zum Abtrennen der über einen Rand (6) eines Gurtbandes (4) übersehenden Teile (7, 8) von in einem bestimmten Abstand (R) zueinander angeordneten Stromzuführungsdrähten (2, 3) radial bedrahteter elektrischer Bauelemente (1), die mit einem die Stromzuführungsdrähte (2, 3) umfassenden Klebeband (5), an dem Gurtband (4) befestigt sind, das wenigstens um einen Abstand (A) breiter ist als das Klebeband (5), sieht vor, daß das Abtrennen der Stromzuführungsdrähte (2, 3) im Bereich des Abstandes (A) zwischen dem Rand (6) des Gurtbandes (4) und dem Rand (9) des Klebebandes (5) erfolgt; das Gurtband (4) weist durch das Abtrennen der Stromzuführungsdrähte (2, 3) entstandene Einschnitte (16) und quer dazu Eindrückungen (18) auf.

FIG 4

Croydon Printing Company Ltd.

SIEMENS AKTIENGESELLSCHAFT          Unser Zeichen

Berlin und München                  VPA 82 P 7 0 5 4 E

Verfahren zum Abtrennen der über einen Rand eines Gurtbandes überstehenden Teile von Stromzuführungsdrähten
radial bedrahteter elektrischer Bauelemente und Gurtband
mit solchen Bauelementen.

Die Erfindung betrifft ein Verfahren zum Abtrennen der
über einen Rand eines Gurtbandes überstehenden Teile von
in einem bestimmten Abstand (Rastermaß R) zueinander angeordneten Stromzuführungsdrähten radial bedrahteter
elektrischer Bauelemente, die mit einem die Stromzuführungsdrähte umfassenden Klebeband an dem Gurtband befestigt sind, das wenigstens um einen Abstand (A)
breiter ist als das Klebeband.

Die Erfindung betrifft ferner ein Gurtband mit radial
bedrahteten elektrischen Bauelementen, die mit einem
Klebeband, das die in einem bestimmten Abstand (Rastermaß R) zueinander angeordneten Stromzuführungsdrähte der
elektrischen Bauelemente umfaßt, an dem Gurtband befestigt sind und bei dem die Stromzuführungsdrähte
zwischen dem Rand des Gurtbandes und dem Rand des Klebebandes enden.

Die Technologie der automatischen Bestückung von
gedruckten Schaltungen mit elektrischen Bauelementen,
die mit Bestückungsautomaten durchgeführt wird und bei
der die Bauelemente in gegurteter Form zugeführt werden,
ist schon länger bekannt und beispielsweise in der Zeitschrift "Siemens-Components", Jahrgang 20, Heft 4, Juli
1982, Seiten 123 bis 128, beschrieben. Die dementsprechende
Veröffentlichung in englischer Sprache ist in der Zeit-

Bck 1 Plr/22.10.1982

schrift "Siemens-Components", Volume XVII, Nr. 4, August
1982, Seiten 123 bis 128, erschienen.

Für die automatische Bestückung gedruckter Schaltungen mit
elektrischen Bauelementen ist es von wesentlicher Bedeutung, daß die Stromzuführungsdrähte der elektrischen Bauelemente das gewünschte Rastermaß (Vielfache von 2,5 mm)
einhalten und daß die Enden der Stromzuführungsdrähte weitgehend unverformt sind, damit sie in die Öffnungen der gedruckten Schaltung ohne Behinderung eingeführt werden
können. Ferner ist es wesentlich, daß die aus einem Vorratsbehälter entnehmbaren und mit den elektrischen Bauelementen bestückten Gurtbänder weitgehend behinderungsfrei
dem Bestückungsautomaten zugeführt werden können.

Die elektrischen Bauelemente müssen somit für dieses Bestückungsverfahren auf einem Gurtband befestigt werden,
wie dies beispielsweise in der deutschen Patentanmeldung
P 32 26 955.2-27 vom 19. Juli 1982 beschrieben ist.

Es gibt für diese Befestigung der Bauelemente an Gurtbändern hauptsächlich zwei Möglichkeiten, die zur Anwendung
gelangen.

Die erste Möglichkeit besteht darin, daß die auf dem Gurtband zu befestigenden elektrischen Bauelemente bereits derart mit Stromzuführungen versehen sind, daß diese in dem
gewünschten Rastermaß vorliegen und in dieser Weise nur mit
einem Klebeband befestigt zu werden brauchen. Die Stromzuführungen ragen dabei nur über den Rand des Klebebandes,
nicht aber über den Rand des Gurtbandes hinaus.

Werden demgegenüber und entsprechend der zweiten Möglichkeit die elektrischen Bauelemente mit Stromzuführungen verbunden, die sich aus Gründen der Herstellungstechnologie
in den Schlitzen von Transportbändern befinden, dann müssen
solche Bauelemente von den Transportbändern entfernt und erst danach auf einem Gurtband mit einem Klebeband befestigt werden.

Die vorliegende Erfindung bezieht sich auf das Gurten der auf diese Weise hergestellten elektrischen Bauelemente. Diese Herstellung ist beispielsweise in der DE-PS 29 48 319 oder in der EP-A2 0 042 137 beschrieben.

Der Begriff "elektrische Bauelemente" wird im Rahmen der vorliegenden Erfindung für elektrische Widerstände, z. B. keramische Kaltleiter, elektrische Kondensatoren, insbesondere Vielschicht-Kondensatoren mit einem keramischen Dielektrikum, sowie allgemein für solche Bauteile benutzt, die einen Körper enthalten, der entweder selbst Teil des elektrischen Bauteils ist (Kondensator, Widerstand, Halbleiter) oder als Trägerplatte für andere elektrische Bauelemente dient (z. B. Schichtschaltung), wobei an diesen Trägerkörper an gegenüberliegenden Seiten je ein Stromzuführungsdraht zu befestigen ist.

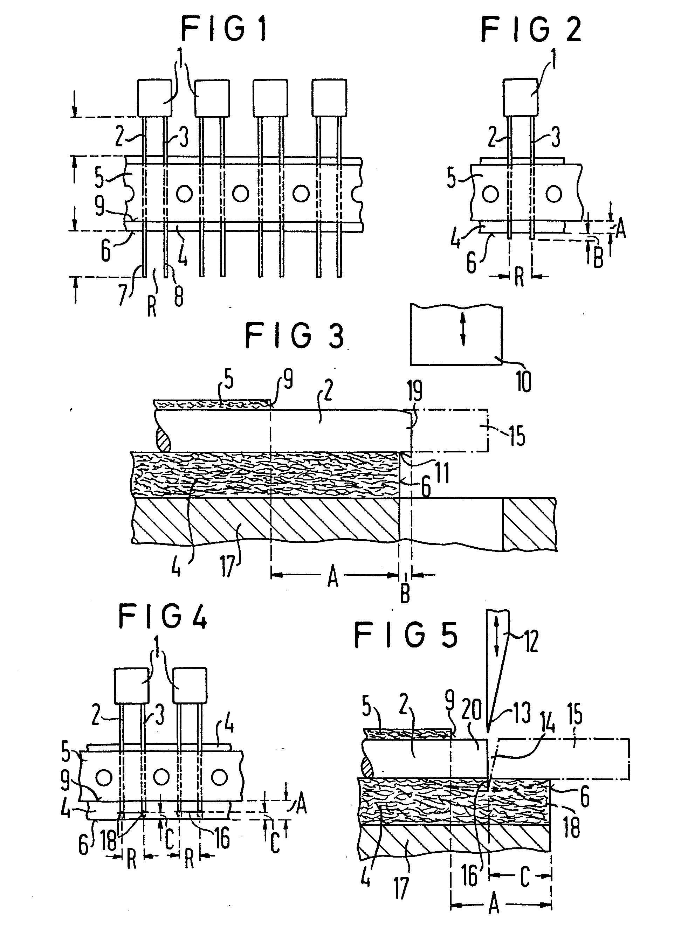

Damit derartige elektrische Bauelemente nach der Herstellung, d. h. vom Transportband auf das Gurtband überführt werden können, ist es erforderlich, daß die freien Enden der Stromzuführungsdrähte mindestens soweit über den Rand des Gurtbandes hinausragen, daß eine Justierung im Rastermaß R möglich ist und ein Schrägstellen des gesamten Bauelementes vermieden wird, wie dies in Figur 1 gezeigt ist. Würde man die Stromzuführungsdrähte der elektrischen Bauelemente auf dem Gurtband mit dem Klebeband derart befestigen, daß (wie es für mit festem Rasterabstand R eingestellten Stromzuführungsdrähten anderer Bauelemente bekannt ist), die Enden der Stromzuführungsdrähte auf dem Gurtband, also zwischen dem Rand des Klebestreifens und dem Rand des Gurtbandes enden, dann wäre nicht gewährleistet, daß bei den hier in Rede stehenden elektrischen Bauelementen das geforderte Rastermaß eingehalten ist und die Schrägstellung vermieden wird.

Bei der bisher bekannten Gurtung dieser Bauelemente hat man deshalb die über den Rand des Gurtbandes zwangsläufig weit hinausragenden Teile der Stromzuführungsdrähte derart abgetrennt, daß ein sehr kurzes Stück, das höchstens zwei mm lang ist, über den Rand des Gurtbandes hinausragt. Auf diese Weise kann das geforderte Rastermaß eingehalten werden, jedoch treten neue Probleme auf, die darin bestehen, daß durch den Abtrennvorgang die Enden der Stromzuführungsdrähte verformt werden und daß die überstehenden Enden der Stromzuführungsdrähte am Boden des für den Bestückungsautomaten erforderlichen Vorratsbehälters für das aufgerollte Gurtband reiben und dadurch nur eine sehr unstete Zufuhr des Gurtbandes zum Bestückungsautomaten ermöglichen.

Der vorliegenden Erfindung liegt die Aufgabe zugrunde, ein Verfahren anzugeben, das es ermöglicht, Gurtbänder zu erhalten, die mit radial bedrahteten elektrischen Bauelementen versehen sind, deren Stromzuführungsdrähte zunächst über den Rand des Gurtbandes hinausragen, dann aber derart abgetrennt sind, daß die Stromzuführungsdrähte das Gurtband nicht mehr überragen; es ist ferner Aufgabe der Erfindung, ein Gurtband anzugeben, das mit radial bedrahteten elektrischen Bauelementen versehen ist, die mit einem Klebeband, das die in einem bestimmten Abstand zueinander angeordneten Stromzuführungsdrähte der elektrischen Bauelemente umfaßt, an dem Gurtband befestigt sind.

Zur Lösung dieser Aufgabe ist das Verfahren zum Abtrennen der über einen Rand eines Gurtbandes überstehenden Teile von in einem bestimmten Abstand (Rastermaß R) zueinander angeordneten Stromzuführungsdrähten radial bedrahteter elektrischer Bauelemente, die mit einem die Stromzuführungsdrähte umfassenden Klebeband an dem Gurtband befestigt sind, das wenigstens um einen Abstand (A) breiter ist als das Klebeband, erfindungsgemäß dadurch gekennzeichnet, daß das Abtrennen der Stromzuführungsdrähte im Bereich

des Abstandes (A) zwischen dem Rand des Gurtbandes und dem Rand des Klebebandes erfolgt.

Dabei ist es besonders vorteilhaft, daß zum Abtrennen ein Abtrennwerkzeug verwendet wird, das eine Schneide aufweist und daß mit dem Abtrennwerkzeug ein keilförmiger Trennschnitt erzeugt wird, der die überstehenden Teile der Stromzuführungsdrähte abtrennt, nur bis in die Oberfläche des Gurtbandes reicht und dort einen Einschnitt erzeugt.

Ferner ist es vorteilhaft, wenn das Abtrennen durch eine kurzzeitige, dem Vorschubtakt der automatischen Fertigung angepaßte Abwärtsbewegung des Abtrennwerkzeuges erfolgt und dabei die Tiefe des keilförmigen Trennschnittes vorgegeben ist, d. h. daß die Eindringtiefe in das Gurtband nur gering ist, z. B. kleiner als 0,5 mm.

Das Gurtband mit radial bedrahteten elektrischen Bauelementen, die mit einem Klebeband, das die in einem bestimmten Abstand (Rastermaß R) zueinander angeordneten Stromzuführungsdrähte der elektrischen Bauelemente umfaßt, an dem Gurtband befestigt sind und die Stromzuführungsdrähte zwischen dem Rand des Gurtbandes und dem Rand des Klebebandes enden, ist zur Lösung der angegebenen Aufgabe erfindungsgemäß dadurch gekennzeichnet, daß die Oberfläche des Gurtbandes durch das Abtrennen der Stromzuführungsdrähte entstandene Einschnitte und quer dazu Eindrückungen aufweist.

Durch die Erfindung wird erreicht, daß auch bei solchen elektrischen Bauelementen, deren Rastermaß der Stromzuführungsdrähte erst beim Aufbringen auf das Gurtband exakt eingestellt werden, die Enden der Stromzuführungsdrähte unverformt sind, die Stromzuführungsdrähte den Rand des Gurtbandes nicht überragen und damit eine Behinderung bei der Entnahme aus der Vorratskassette für das aufgerollte Gurtband nicht ergeben und daß dennoch die für den automatischen Bestückungsvorgang der gedruckten Schaltungsplatinen erforderliche Breite des Gurtbandes eingehalten wird.

Die Erfindung wird nachfolgend anhand der beigefügten
Figuren erläutert. Es zeigen:

Figur 1 ein mit radial bedrahteten Bauelementen bestücktes Gurtband,

Figur 2 das Gurtband gemäß Figur 1, nachdem die überstehenden Teile der Stromzuführungsdrähte in der
bisher bekannten Weise abgetrennt worden sind,

Figur 3 den bisher angewandten Abtrennvorgang,

Figur 4 das Gurtband mit radial bedrahteten elektrischen Bauelementen nach der Abtrennung gemäß
der vorliegenden Erfindung und

Figur 5 schematisch den Abtrennvorgang gemäß der vorliegenden Erfindung.

Die in Figur 1 dargestellten Bauelemente 1, die mit
Stromzuführungsdrähten 2, 3 versehen sind, sind auf einem
Gurtband 4 befestigt, indem ein Klebeband 5 die Stromzuführungsdrähte 2 und 3 umfaßt. In der Mitte des Gurtbandes 4 sind Löcher vorgesehen, die für den Transport des
Gurtbandes von Bedeutung sind, jedoch für die vorliegende
Erfindung außer Betracht bleiben können.

Die Teile 7 und 8 der Stromzuführungsdrähte 2 und 3 überragen den Rand 6 des Gurtbandes 4 um einen bestimmten Abstand, damit zwischen den Stromzuführungsdrähten 2 und 3
bei der Bestückung des Gurtbandes der geforderte Rasterabstand R eingehalten werden kann und damit auch die gewünschte Lage des Bauelementes quer zur Längsrichtung
des Gurtbandes 4 eingehalten wird.

Das Gurtband 4 ist breiter als das Klebeband 5, so daß der Rand 9 des Klebebandes 5 um einen gewissen Abstand A gegenüber dem Rand 6 des Gurtbandes 4 versetzt ist.

Die radial bedrahteten elektrischen Bauelemente 1 sind beispielsweise gemäß einem Verfahren hergestellt, das in der oben bereits erwähnten DE-PS 29 48 319 oder der ebenfalls oben bereits erwähnten EP-A2 0 042 137 beschrieben ist.

Aus dem für das bekannte Verfahren zu verwendendem Transportband werden die elektrischen Bauelemente entnommen, auf das Gurtband 5 aufgelegt und mit dem Klebeband 4 befestigt, wie dies in der ebenfalls oben bereits erwähnten deutschen Patentanmeldung P 32 26 955.2-27 beispielsweise erläutert ist.

Bei dem bisher bekannten Abtrennen der überstehenden Teile 7, 8 der Stromzuführungsdrähte 2, 3 wurde ein Stempel 10 benutzt (vergl. Figur 3), der die Stromzuführungsdrähte 2 und 3 abgetrennt hat, so daß ein den Rand 6 des Gurtbandes 4 um den Abstand B überragender Endteil des Stromzuführungsdrahtes entstand.

Die Kante 11 des Gurtbandes 4 wurde zusammen mit der Unterlage 17 als Schneidkante ausgenutzt.

Die Ausnutzung der Kante 11 des Gurtbandes 4 als Unterlage für den Abtrennvorgang durch Einwirkung des Abtrennwerkzeuges 10 führt dazu, daß das Ende 19 der Stromzuführungsdrähte 2, 3 verformt ist.

Das Überstehen der Stromzuführungsdrähte mit Abstand B über den Rand 6 des Gurtbandes 4 führt zu einer Reibung auf dem Boden des Vorratsbehälters (Kassette), wenn ein dermaßen bestücktes Gurtband zu einer großen Rolle aufgewickelt in einer Kassette untergebracht ist. Ferner kann das verformte Ende 19 der Stromzuführungsdrähte 2 und 3 ihr Einführen in die Öffnungen der gedruckten Schaltungsplatine behindern, obwohl der gewünschte Abstand, das Rastermaß R, eingehalten ist, es sei denn, daß bei der automatischen Bestückung die Stromzuführungsdrähte nochmals gekürzt werden.

Diese Nachteile und Schwierigkeiten der bisher verwendeten Technik werden durch die vorliegende Erfindung vermieden.

Dies geht aus den Figuren 4 und 5 hervor, wo gezeigt ist, daß die Stromzuführungsdrähte 2 und 3 zwischen dem Rand 9 des Klebebandes 5 und dem Rand 6 des Gurtbandes 4, zwischen denen der Abstand A vorliegt, abgetrennt sind.

Dieser Abtrennvorgang erfolgt durch das mit einer Schneide 13 vesehene Abtrennwerkzeug 12, wodurch ein keilförmiger Trennschnitt 14 bewirkt wird, der die überstehenden Teile 15 der Stromzuführungsdrähte 2, 3 abtrennt, nur bis in die Oberfläche des Gurtbandes 4 reicht und dort einen Einschnitt 16 erzeugt.

Bei diesem Trennvorgang werden zwar die Stromzuführungsdrähte 2 und 3 geringfügig verbogen, so daß neben dem Einschnitt 16 auch Eindrückungen 18 entstehen, jedoch hat es sich bei der Durchführung dieses Verfahrens gezeigt, daß die Stromzuführungsdrähte 2 und 3 unverformte Enden 20 bilden, weil während des Trennvorganges das Gurtband 4 auch über das abzutrennende Ende 20 hinaus als Unterlage wirkt, und zwar im Zusammenwirken mit der Unterlage 17, auf der das Gurtband 4 geführt wird.

Die Eindrückungen 18 sind quer zu den Einschnitten 16 angeordnet, welche in Längsrichtung des Gurtbandes 4 verlaufen.

0109526

82 P 7054 E

Die Abtrennung erfolgt somit im Bereich des Streifens, der den Abstand A zwischen dem Rand 9 des Klebebandes 5 und dem Rand 6 des Gurtbandes 4 bildet.

Der Abstand C zwischen dem Trenneinschnitt 16 und dem Rand 6 des Gurtbandes 4 ist etwa halb so groß wie der Abstand A.

4 Patentansprüche
1 Bezugszeichenliste
1 Zusammenfassung
1 Blatt Zeichnungen

0109526

Bezugszeichenliste

1    elektrisches Bauelement
2    Stromzuführungsdraht
3    Stromzuführungsdraht
4    Gurtband
5    Klebeband
6    Rand des Gurtbandes 4
7    abzutrennender Teil des Stromzuführungsdrahtes 7
8    abzutrennender Teil des Stromzuführungsdrahtes 8
9    Rand des Klebebandes 5
10   Abtrennwerkzeug in Form eines Stempels
11   Kante des Gurtbandes 4
12   Abtrennwerkzeug mit Schneide
13   Schneide des Abtrennwerkzeuges 12
14   keilförmiger Trennschnitt
15   überstehende Teile der Sstromzuführungsdrähte 2, 3
16   Einschnitt in der Oberfläche des Gurtbandes 4
17   Unterlage, auf der das Gurtband 4 geführt wird
18   Eindrückung in der Oberfläche des Gurtbandes 4
     quer zu den Einschnitten 16
19   verformte Enden der Stromzuführungsdrähte 2, 3
20   unverformte Enden der Stromzuführungsdrähte 2, 3


R    Rastermaß
A    Abstand zwischen dem Rand 6 des Gurtbandes 4 und
     dem Rand 9 des Klebebandes 5
B    überstehender Rest der Teile 7 und 8 der Stromzuführungsdrähte 2 und 3
C    Abstand zwischen den Enden der Stromzuführungsdrähte 2, 3 und dem Rand 6 des Gurtbandes 4

Patentansprüche

1. Verfahren zum Abtrennen der über einen Rand (6) eines Gurtbandes (4) überstehenden Teile (7, 8) von in einem bestimmten Abstand (Rastermaß R) zueinander angeordneten Stromzuführungsdrähten (2, 3) radial bedrahteter elektrischer Bauelemente (1), die mit einem die Stromzuführungsdrähte (2, 3) umfassenden Klebeband (5) an dem Gurtband (4) befestigt sind, das wenigstens um einen Abstand (A) breiter ist als das Klebeband (5), d a d u r c h   g e k e n n z e i c h n e t , daß das Abtrennen der Stromzuführungsdrähte (2, 3) im Bereich des Abstandes (A) zwischen dem Rand (6) des Gurtbandes (4) und dem Rand (9) des Klebebandes (5) erfolgt.

2. Verfahren nach Anspruch 1, d a d u r c h   g e -
k e n n z e i c h n e t , daß zum Abtrennen ein Abtrennwerkzeug (12) verwendet wird, das eine Schneide (13) aufweist, und daß mit dem Abtrennwerkzeug (12) ein keilförmiger Trennschnitt (14) erzeugt wird, der die überstehenden Teile (15) der Stromzuführungsdrähte (2, 3) abtrennt, nur bis in die Oberfläche des Gurtbandes (4) reicht und dort einen Einschnitt (16) erzeugt.

3. Verfahren nach Anspruch 2, d a d u r c h   g e -
k e n n z e i c h n e t , daß das Abtrennen durch eine kurzzeitge, dem Vorschubtakt der automatischen Fertigungen angepaßte Abwärtsbewegung des Abtrennwerkzeuges (12) erfolgt und dabei die Tiefe des keilförmigen Trennschnittes (14) vorgegeben ist.

4. Gurtband mit radial bedrahteten elektrischen Bauelementen (1), die mit einem Klebeband (5), das die in einem bestimmten Abstand (Rastermaß R) zueinander angeordneten Stromzuführungsdrähte (2, 3) der elektrischen Bauelemente (1) umfaßt, an dem Gurtband (4) befestigt sind und die Stromzuführungsdrähte (2, 3) zwischen dem Rand (6) des Gurtbandes (4) und dem Rand (9) des Klebebandes (5) enden, d a d u r c h   g e k e n n z e i c h -
n e t ,   daß die Oberfläche des Gurtbandes (4) durch das
Abtrennen der Stromzuführungsdrähte (2, 3) entstandene
Einschnitte (16) und quer dazu Eindrückungen (18)
aufweist.

0109526

1/1

FIG 1

FIG 2

FIG 3

FIG 4

FIG 5